Europäisches Patentamt

European Patent Office

Office européen des brevets

(19)

(11) EP 0 539 132 B1

(12) EUROPEAN PATENT SPECIFICATION

(45) Date of publication and mention
of the grant of the patent:
**17.03.1999  Bulletin 1999/11**

(51) Int Cl.⁶: **H04B 1/08**, H05K 9/00

(21) Application number: **92309518.6**

(22) Date of filing: **19.10.1992**

(54) **EMC-enclosure**

Abgeschirmtes Gehäuse für elektromagnetische Kompatibilität

Boîtier écran pour la compatibilité électromagnétique

(84) Designated Contracting States:
**DE FR GB SE**

(30) Priority: **22.10.1991  FI   914978**

(43) Date of publication of application:
**28.04.1993   Bulletin 1993/17**

(73) Proprietor: **NOKIA MOBILE PHONES LTD.**
**24101 Salo (FI)**

(72) Inventor: **Lonka, Pekka**
**SF-24240 Salo (FI)**

(74) Representative: **Frain, Timothy John**
**Patent Department**
**Nokia Mobile Phones**
**St Georges Court**
**St Georges Road**
**Camberley, Surrey GU15 3QZ (GB)**

(56) References cited:
US-A- 3 816 911          US-A- 4 337 444
US-A- 4 838 475          US-A- 5 014 160

EP 0 539 132 B1

## Description

The invention relates to an EMC enclosure with side walls and a cover, which is easy to open for service or repair work the side walls and cover being formed by the same plate preform.

EMC or the Electromagnetic Compatibility is defined as the ability of electronic equipment and systems to keep the ratios of useful signals to interference signals such that the performance characteristics of the equipment are not impaired when they are simultaneously used for their intended purpose in an acceptable environment.

The more exacting EMC requirements impose ever more requirements on electric and telecommunications equipment. The equipment must withstand interference of certain type and level. Also the equipment must not radiate too much interference into the environment.

Enclosures must be used in radiotelephones due to the EMC protection in order to decrease radiation emission and to increase the radiation tolerance of sensitive parts. The enclosures will contain several components, requiring a cover which can be opened for service and repair works in order to reach the components inside the casing.

In order to obtain an enclosure which can be opened there is used a separate cover, as is well known, which along its edges can be fastened to the frame of the EMC enclosure, thus coming into an electric and galvanic contact. This known construction has a disadvantage in that manufacturing a separate cover and fastening it to its frame causes material and labour costs. A separate cover also introduces a component item of the radiotelephone, the handling and updating of which causes extra costs.

In the known construction there can be a poor contact between the cover and the frame due to tolerances, or the cover contact could be insufficient, due to oxidation or high frequency characteristics. Then at high frequencies the cover or a part of it will rise to an impedance and begin to radiate or to receive radiation. The protective effect of the EMC enclosure or a part of it is then lost.

In practice there are several enclosed parts within the radio unit, whereby the above mentioned disadvantages have a large effect. On the other hand only a few EMC enclosures must be opened for service or repair. Therefore most covers are unnecessary components, as they must not be opened during the lifetime of the radiotelephone. Individual covers, due to oxidation reasons and the increase of the number of components, partly impair the reliability and further the impairment of performance characteristics due to any internal interferences.

US 5 014 160 and US 4 337 444 each disclose an EMC enclosure comprising a lower member and an upper member which comprises a cover and downwardly-bent extensions for engaging the lower member. Between the extensions are openings whose longest dimensions are perpendicular to the bends between the cover and the adjacent extensions.

US 4,838,475 discloses a shield folded from a plate having several through-holes to allow reflow soldering of a device insulated by the shield.

An objective of the present invention is to provide an EMC enclosure, which should be of high quality and save costs compared with prior solutions.

According to the present invention there is provided an EMC enclosure for providing component protection in an electrical apparatus, comprising a plate preform providing: a cover (16), side walls (15) bent from the cover, and a the bending area (3) between the cover (16) and the side walls (15) for allowing opening and closing of the enclosure and having openings (13) in a U-form, so that strips (10) formed thereby can be bent to form brackets for a cable passing along the ends of the enclosure.

An embodiment of the invention is described in detail below, by way of example, with reference to the accompanying drawings, in which:

Figure 1 shows a preform cut off from thin metal plate for an EMC enclosure according to the invention;

Figure 2 shows an enlarged part of the preform; and

Figure 3 shows a completed EMC enclosure according to the invention.

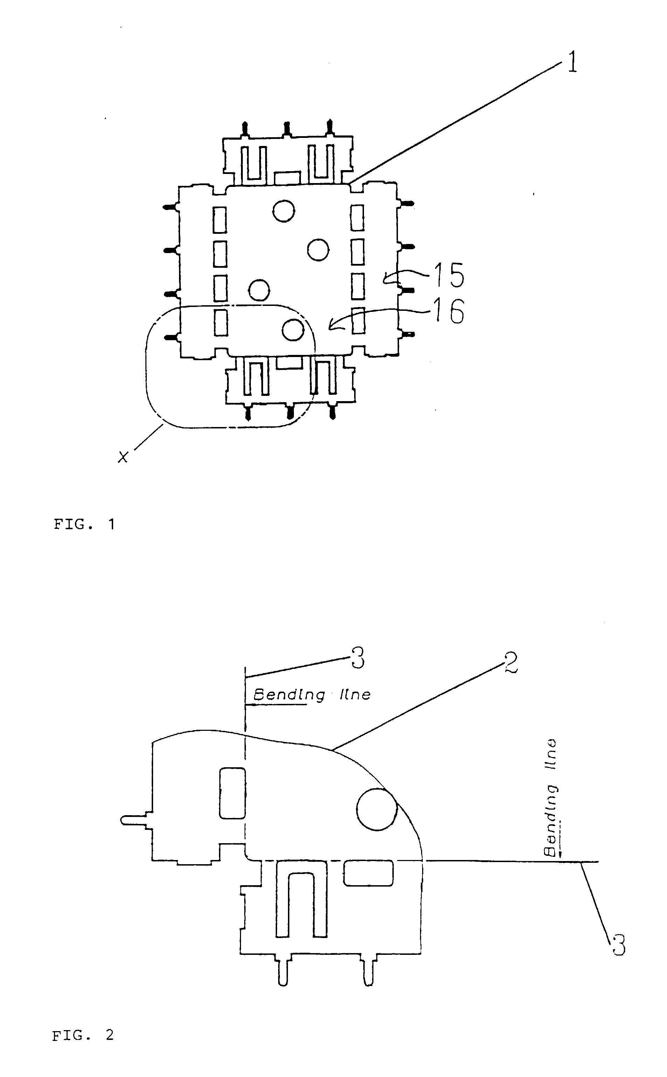

Figure 1 shows a preform 1 cut off from a thin metal plate for an EMC enclosure according to the invention. E.g. nickel silver plate can be used as the metal plate (s = 0,3 mm).

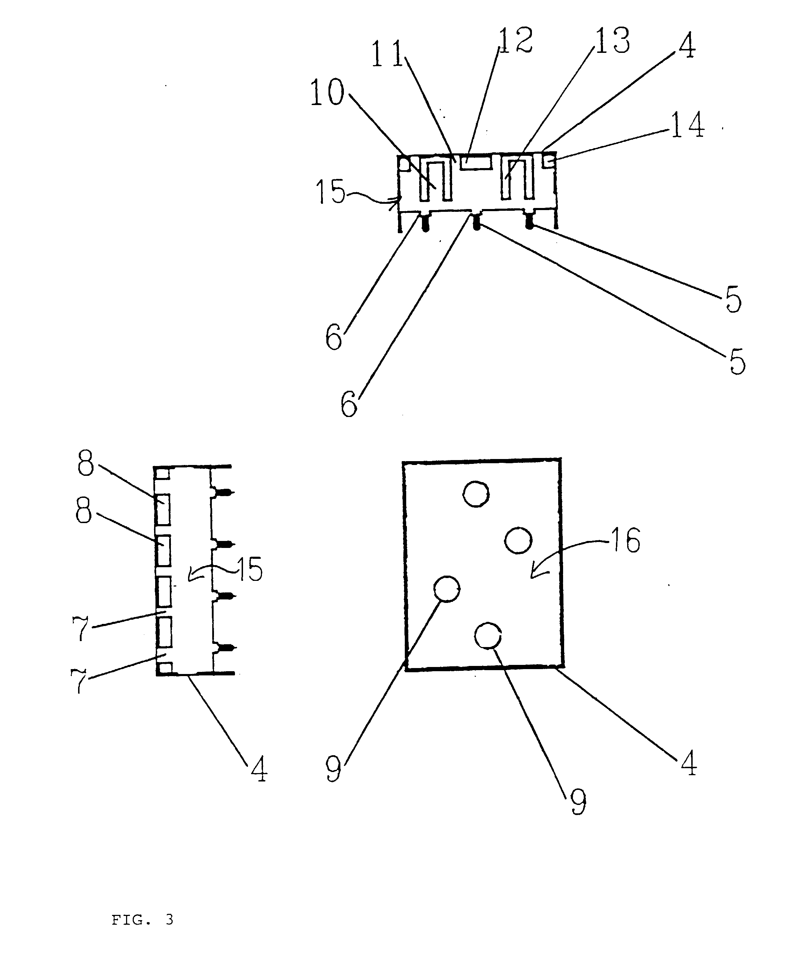

Figure 2 shows an enlarged part 2 of the preform, whereby the detailed structure of the preform appears more clearly. A completed EMC enclosure according to the invention is obtained when the preform sides are bent along the bending lines 3.

Figure 3 shows a completed EMC enclosure 4 according to the invention. The enclosure 4 is wave soldered onto a circuit board with the aid of teeth 5. The enclosure can also be reflow-soldered, whereby the tooth 5 is perpendicularly cut off at the tooth shoulder 6, so that the shoulder acts as a surface mount contact fixed to the circuit board with the solder. When the enclosure is mounted the tooth shoulders 6 act as limiters leaving between the side wall and the circuit board a gap as a passage for signal conductors into and out from the enclosure, the conductors being formed by foils on the circuit board surface.

When the enclosure has been fastened to the circuit board it is possible to open the cover of the enclosure 4 by cutting the necks 7, 11 on three sides. Then the edge between the cover and the fourth side acts as a hinge. Side-cutting pliers or a suitable tool can be used to cut off the necks 7, 11, the cutting edges of the tool being pushed a bit through the openings 8, 12, 13, 14.

The opened cover can be closed by turning it into its original position and by soldering together the cut-off necks 7, 11. For the closing it is also possible to use a separate repair cover, which is soldered or otherwise fastened to the enclosure 4. Then the necks 7, 11 are cut off at four sides and the original cover is removed.

The holes 9 shown in figure 3 are for the adjustment of trimmers inside the enclosure 4. The trimmers can be adjusted with an adjustable spanner which is inserted through a hole 9. The holes are made symmetrical to the axis of the enclosure, whereby the enclosure has no mounting polarity.

A part of the openings in figure 3 are made in a U-form 13, so that the strips 10 formed thereby can be bent to form brackets for a cable passing along the ends of the enclosure 4.

The dimensions of the necks 7, 11 have an effect on the protective characteristics of the enclosure, so that the smaller inductance the neck 7, 11 has, and the more there are necks 7, 11, the lower impedance the neck 7, 11 will have and the better protective effect there will be. The inductance of the neck 7, 11 decreases when the neck 7, 11 is shortened and broadened.

The holes 9 in the enclosure 4 decrease the attenuation of the enclosure 4 according to the approximative formula below, whereby the biggest hole 9 is the effective hole:

$$A = 97 \text{ dB} - 10 \lg(l * W * f * f)$$

in which

l = length of the hole, in millimeters
w = width of the hole, in millimeters
f = effective frequency, in MHz

Due to the enclosure no separate cover is needed. There will be no extra component item, which saves material costs, labour costs and component costs. In an enclosure 4 the cover material is obtained from the central part of the same plate, out of which the frames are cut off. There is no separate mounting phase for the cover, so it will not give rise to any labour costs.

In the enclosure 4 the cover makes the contact via the necks 7, 11, which is substantially better than the prior solution. The neck 7, 11 is of continuous material without easily oxidating connection points. The enclosure 4 is far more reliable than prior enclosures.

## Claims

1. An EMC enclosure for providing component protection in an electrical apparatus, comprising a plate preform providing:

a cover (16),

side walls (15) bent from the cover, and

an arrangement in the bending area (3) between the cover (16) and the side walls (15) for allowing opening and closing of the enclosure and having openings (13) in a U-form, so that strips (10) formed thereby can be bent to form brackets for a cable passing along the ends of the enclosure.

2. An EMC enclosure as claimed in claim 1, wherein the bending area (3) between the cover (16) and one side wall (15) is flexible.

3. An EMC enclosure as claimed in claim 1 or 2, wherein the arrangement on three sides in the bending area (3) comprises necks (7,11) and openings (8,12,13,14) between the necks.

4. An EMC enclosure as claimed in any preceding claim, wherein teeth (5) for aiding the soldering of the enclosure to a circuit board extend from the edges of the side walls opposite the bending area (3).

5. An EMC enclosure as claimed in any preceding claim, wherein shoulders (6) for acting as limiters leaving between the side walls and a circuit board a gap as a passage for signals into and out from the enclosure extend from the edges of the side walls (15) opposite the bending area (3).

6. An EMC enclosure as claimed in claim 5, wherein the EMC enclosure can be surface mount soldered to the circuit board by means of the shoulders.

7. A plate preform for an EMC enclosure, comprising a cover region (16) linked by a bending area (3) for allowing opening and closing of the enclosure to side wall regions (15), there being openings (13) in the bending area in a U-form, so that strips (10) formed thereby can be bent to form brackets for a cable passing along the ends of the enclosure.

## Patentansprüche

1. EMV-Gehäuse zum Komponentenschutz in einem elektrischen Gerät, mit einer Plattenvorform mit:

- einem Deckel (16),
- vom Deckel abgebogenen Seitenwänden (15), und
- einer Anordnung im Biegebereich zwischen dem Deckel (16) und den Seitenwänden (15), die ein Öffnen und Schließen des Gehäuses gestattet und die U-förmige Öffnungen (13) aufweist, so daß dadurch gebildete Streifen (10) gebogen werden können, um Klammern für ein entlang der Enden des Gehäuses laufendes Kabel zu bilden.

2. EMV-Gehäuse nach Anspruch 1, wobei der Biegebereich (3) zwischen dem Deckel (16) und einer Seitenwand (15) flexibel ist.

3. EMV- Gehäuse nach Anspruch 1 oder 2, wobei die Anordnung an drei Seiten im Biegebereich (3) Stege (7, 11) und Öffnungen (8, 12, 13, 14) zwischen den Stegen umfaßt.

4. EMV-Gehäuse nach einem der vorstehenden Ansprüche, wobei sich Zähne (5) zur Unterstützung des Auflötens des Gehäuses auf eine Leiterplatte von den zum Biegebereich (3) entgegengesetzten Kanten wegerstrecken.

5. EMV-Gehäuse nach einem der vorstehenden Ansprüche, wobei sich Schultern (6) von den entgegengesetzt zum Biegebereich (3) liegenden Kanten der Seitenwände (15) wegerstrecken, um als Begrenzer zu wirken, die zwischen den Seitenwänden und einer Leiterplatte eine Lücke als Durchgang für Signale in das und aus dem Gehäuse belassen.

6. EMV-Gehäuse nach Anspruch 5, wobei das EMV-Gehäuse mittels der Schultern auf der Leiterplatte oberflächenmontiert verlötet werden kann.

7. Plattenvorform für ein EMV-Gehäuse, mit einem Deckelbereich (16), der durch einen Biegebereich (3) zum Öffnen und Schließen des Gehäuses mit Seitenwandbereichen (15) verbunden ist, wobei U-förmige Öffnungen im Biegebereich sind, so daß dadurch gebildete Streifen (10) umgebogen werden können, um Klammern für ein entlang der Enden des Gehäuses laufendes Kabel bilden zu können.

**Revendications**

1. Enceinte EMC pour procurer une protection au composant dans un dispositif électrique, comprenant une préforme sous forme de plaque comprenant :

    un couvercle (16)
    des parois latérales (15) recourbées à partir du couvercle et
    une disposition dans la zone de courbure 3 située entre le couvercle (16) et les parois latérales (15) pour permettre l'ouverture et la fermeture de l'enceinte et comportant des ouvertures (13) en une forme de U de sorte que les bandes (10) formées par celles-ci peuvent être recourbées pour former des colliers pour un câble passant le long des extrémités de l'enceinte.

2. Enceinte EMC selon la revendication 1, dans laquelle la zone de courbure (3) située entre le couvercle (16) et une paroi latérale (15) est flexible.

3. Enceinte EMC selon la revendication 1 ou 2, dans laquelle la disposition sur les trois côtés dans la zone de courbure (3) comprend des rebords (7, 11) et des ouvertures (8, 12, 13, 14) entre les rebords.

4. Enceinte EMC selon l'une quelconque des revendications précédentes, dans laquelle les dents (5) pour aider à la soudure de l'enceinte à une carte de circuit s'étendent à partir des bords des parois latérales opposées à la zone de courbure (3).

5. Enceinte EMC selon l'une quelconque des revendications précédentes, dans laquelle des épaulements (6) pour agir comme limiteurs laissant entre les parois latérales et une carte de circuit un espace comme un passage pour les signaux entrant et sortant de l'enceinte se prolongent à partir des bords des parois latérales (15) opposées à la zone de courbure (3).

6. Enceinte EMC selon la revendication 5, dans laquelle l'enceinte EMC peut être soudée par montage en surface sur la carte de circuit au moyen d'épaulements.

7. Préforme sous forme de plaque pour une enceinte EMC, comprenant une région de couvercle (16) raccordée par une zone de courbure (3) pour permettre l'ouverture et la fermeture de l'enceinte aux régions de parois latérales (15), des ouvertures (13) étant ménagées dans la zone de courbure en une forme de U, de sorte que des bandes (10) formées par celles-ci peuvent être recourbées pour former des colliers pour passer un câble le long des extrémités de l'enceinte.

1

15

16

X

FIG. 1

3

Bending line

2

Bending line

3

FIG. 2

FIG. 3